# EUROPEAN PATENT APPLICATION

(11) **EP 3 845 801 A1**
(43) Date of publication of application: **07.07.2021**
(21) Application number: 18931845.4
(22) Date of filing: 28.08.2018
(51) Int. Cl.: F21S 43/14, F21S 43/242

(54) **VEHICULAR LAMP USING SEMICONDUCTOR LIGHT EMITTING ELEMENT**

(71) Applicant: ZKW Group GmbH, 3250 Wieselburg (AT)
(72) Inventor: JUNG, Mongkwon, Seoul 06772 (KR); CHA, Joongtaek, Seoul 06772 (KR)
(74) Representative: Patentanwaltskanzlei Matschnig & Forsthuber OG
(86) International application number: PCT/KR2018/009911
(87) International publication number: WO 2020/045696

(57) **Abstract**

The present invention provides a lamp characterized by comprising: a half mirror which is provided with a top surface and a bottom surface, and which reflects a portion of light incident on the bottom surface and discharges another portion of the light to the outside; a reflection layer disposed facing the bottom surface of the half mirror; light guides which are disposed between the half mirror and the reflection layer, and each of which is provided with one end and the other end and totally reflects a portion of light incident on the one end and discharges the light to the outside through the other end; and a plurality of light sources, each of which emits light, wherein the one end overlaps with the light source so that the light emitted from the light source is incident on the one end, and the other end of the light guide passes through the half mirror..

## Description

### TECHNICAL FIELD

The present disclosure relates to a vehicle lamp (or car lamp) and a control method thereof, and more particularly, a vehicle lamp using a semiconductor light emitting device.

### BACKGROUND ART

A vehicle or car is equipped with various lamps having lighting functions and signaling functions. In general, halogen lamps or gas discharge lamps are usually used, but in recent years, light emitting diodes (LEDs) are in the spotlight as light sources for vehicle lamps.

The LED can enhance a degree of freedom for design of a lamp by minimizing a size thereof and exhibit economical efficiency by virtue of a semi-permanent lifespan, but most of the LEDs are currently produced in a form of a package. The LED itself other than the package is under development as a semiconductor light emitting device of converting a current into light, namely, an image displaying light source equipped in an electronic device such as an information communication device.

In recent years, attempts have been made to vary an illumination (lighting) pattern of a lamp as the size of the semiconductor light emitting device decreases. However, in order to realize various illumination patterns, structures other than a light source are required, which causes an increase in the size of the lamp, a decrease in brightness, and the like. As a result, various implementations of the illumination pattern of the lamp are limited.

### DETAILED DESCRIPTION OF THE DISCLOSURE

### TECHNICAL PROBLEM

One aspect of the present disclosure is to provide a lamp capable of realizing a stereoscopic illumination pattern while minimizing a thickness thereof.

Another aspect of the present disclosure is to provide a lamp capable of implementing various illumination patterns.

Still another aspect of the present disclosure is to provide a lamp that can be utilized as a turn signal lamp for a vehicle.

### TECHNICAL SOLUTION

To achieve the aspects and other advantages of the present disclosure, there is provided a lamp, including: a half mirror having an upper surface and a lower surface, and configured to reflect a part of light entering the lower surface and another part to be discharged outside; a reflector disposed to face the lower surface of the half mirror; light guides disposed between the half mirror and the reflector, each having one end and another end, so that a part of light incident to the one end is totally reflected to be discharged to the another end; and a plurality of light sources emitting light, wherein the one end overlaps the light source, so that light emitted from the light source is incident to the one end, and the another end of the light guide penetrates the half mirror.

In one embodiment, the light guide may extend from the reflector in a direction perpendicular to a plane on which the reflector is provided and penetrate the half mirror.

In one embodiment, the light guide may have a plurality of side surfaces connecting the one end and the another end, and a part of the light incident to the one end may be discharged to the plurality of side surfaces and repeatedly reflected by the half mirror and the reflector.

In one embodiment, the light sources may be disposed to be spaced apart from each other by a predetermined distance, and the light guide may be arranged to overlap each of the light sources.

In one embodiment, the light guide may have a plurality of side surfaces connecting the one end and the another end, and the present disclosure may further include a plurality of side reflectors disposed to cover the plurality of side surfaces and an auxiliary light source disposed on the side reflector.

In one embodiment, the auxiliary light source may be disposed between the half mirror and the reflector so that light emitted from the auxiliary light source is repeatedly reflected between the half mirror and the reflector.

In one embodiment, the light guide may have a plurality of side surfaces connecting the one end and the another end, and the lamp may further include surface light sources disposed to cover the plurality of side surfaces.

In one embodiment, the surface light source may be disposed between the half mirror and the reflector and be disposed perpendicular to a plane on which the reflector is provided so that light emitted from the surface light source is repeatedly reflected between the half mirror and the reflector.

In one embodiment, the light guide may have a plurality of side surfaces connecting the one end and the another end, and the present disclosure may further include a side reflector disposed to cover some of the plurality of side surfaces and a surface light source disposed to cover a remaining part of the plurality of side surfaces.

In one embodiment, the side reflector and the surface light source may be disposed to face each other.

In one embodiment, the light guides may overlap some of the light sources.

In one embodiment, at least one light source that does not overlap the light guide may be disposed between the light guides.

In one embodiment, the present disclosure may further include a controller configured to receive a control command generated during a driving of a vehicle and selectively turn on the light sources based on the control command.

In one embodiment, the controller, in a state that at least some of the light sources are all turned off, may sequentially turn on the at least some of the light sources in one direction until the at least some of the light sources are all turned on.

In one embodiment, a time interval from when one of the at least some of the light sources is turned on until when all of the at least some of the light sources are turned on may range from 115 to 195 ms.

In one embodiment, each of the light sources may be disposed between the half mirror and the reflector, and may be disposed on the reflector.

In one embodiment, each of the light sources may be disposed at a lower side of the reflector, and the light guide may be disposed to penetrate the reflector such that the one end overlaps the light source.

### ADVANTAGEOUS EFFECTS

According to the present disclosure, it is not necessary to arrange light sources three-dimensionally in order to realize a stereoscopic illumination pattern. Accordingly, the present disclosure can realize the stereoscopic illumination pattern while maintaining a slim thickness of the lamp.

Further, according to the present disclosure, a part of light emitted from the light source is immediately discharged outside through the light guide, and another part of the light emitted from the light source is repeatedly reflected between the half mirror and the reflector and then discharged to the outside. The present disclosure secures a quantity of light of the lamp through the light guide, and realizes a stereoscopic illumination pattern through the half mirror and the reflector.

### BRIEF DESCRIPTION OF THE DRAWINGS

FIG. 1 is a conceptual view illustrating one embodiment of a lamp for a vehicle (or a vehicle lamp) using a semiconductor light emitting device according to the present disclosure.
FIG. 2 is a conceptual view illustrating a flip chip type semiconductor light emitting device.
FIG. 3 is a conceptual view illustrating a vertical type semiconductor light emitting device.
FIG. 4 is a conceptual view illustrating a cross section of a lamp according to the present disclosure.
FIG. 5 is a conceptual view illustrating a cross section of a lamp including an auxiliary light source according to the present disclosure.
FIG. 6 is a conceptual view illustrating a cross section of a lamp including a surface light source according to the present disclosure.
FIG. 7 is a conceptual view illustrating a cross section of a lamp including a surface light source and a side reflector according to the present disclosure.

### MODES FOR CARRYING OUT PREFERRED EMBODIMENTS

Description will now be given in detail according to exemplary embodiments disclosed herein, with reference to the accompanying drawings. For the sake of brief description with reference to the drawings, the same or equivalent components may be provided with the same or similar reference numbers, and description thereof will not be repeated. In general, a suffix such as "module" and "unit" may be used to refer to elements or components. Use of such a suffix herein is merely intended to facilitate description of the specification, and the suffix itself is not intended to give any special meaning or function. In describing the present disclosure, if a detailed explanation for a related known function or construction is considered to unnecessarily divert the gist of the present disclosure, such explanation has been omitted but would be understood by those skilled in the art. The accompanying drawings are used to help easily understand the technical idea of the present disclosure and it should be understood that the idea of the present disclosure is not limited by the accompanying drawings.

It will be understood that when an element such as a layer, area or substrate is referred to as being "on" another element, it can be directly on the element, or one or more intervening elements may also be present.

A vehicle lamp described in this specification may include a head lamp, a tail lamp, a position lamp, a fog lamp, a turn signal lamp, a brake lamp, an emergency lamp, a backup lamp, and the like. However, it will be readily apparent to those skilled in the art that the configuration according to the embodiments described herein may also be applied to a new product type that will be developed later if the device is a device capable of emitting light.

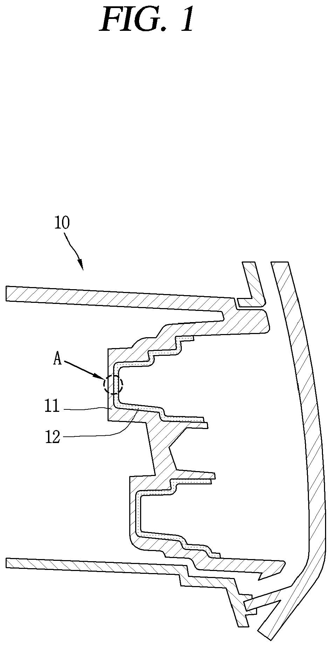

FIG. 1 is a conceptual view illustrating one embodiment of a lamp for a vehicle (or a vehicle lamp) using a semiconductor light emitting device according to the present disclosure.

A vehicle lamp 10 according to one embodiment of the present disclosure includes a frame 11 fixed to a vehicle body, and a light source unit 12 installed on the frame 11.

A wiring line for supplying power to the light source unit 12 may be connected to the frame 11, and the frame 11 may be fixed to the vehicle body directly or by using a bracket. According to the present disclosure, the vehicle lamp 10 may be provided with a lens unit to more diffuse and sharpen light emitted from the light source unit 12.

The light source unit 12 may be a flexible light source unit that can be curved, bent, twisted, folded, or rolled by external force.

In a non-curved state of the light source unit 12 (for example, a state having an infinite radius of curvature, hereinafter, referred to as a first state), the light source unit 12 is flat. When the first state is switched to a state that the light source unit 12 is bent by an external force (e.g., a state having a finite radius of curvature, hereinafter, referred to as a second state), the flexible light source unit may have a curved surface with at least part curved or bent.

A pixel of the light source unit 12 may be implemented by a semiconductor light emitting device. The present disclosure exemplarily illustrates a light emitting diode (LED) as a type of semiconductor light emitting device for converting current into light. The LED may be a light emitting device having a small size, and may thus serve as a pixel even in the second state.

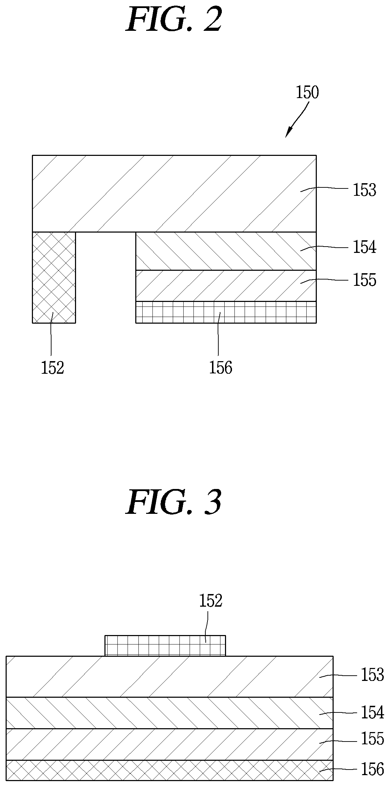

FIG. 2 is a conceptual view illustrating a flip chip type semiconductor light emitting device, and FIG. 3 is a conceptual view illustrating a vertical type semiconductor light emitting device.

Since the semiconductor light emitting device 150 has excellent brightness, it can constitute an individual unit pixel even though it has a small size. The size of the individual semiconductor light emitting device 150 may be less than 80 µm in the length of one side thereof, and may be a rectangular or square shaped device. In this case, an area of the single semiconductor light emitting device is in the range of 10-10 to 10-5 m², and an interval between light emitting devices may be in the range of 100 um to 10 mm.

Referring to FIG. 2, the semiconductor light emitting device 150 may be a flip chip type light emitting device.

For example, the semiconductor light emitting device includes a p-type electrode 156, a p-type semiconductor layer 155 on which the p-type electrode 156 is formed, an active layer 154 disposed on the p-type semiconductor layer 155, an n-type electrode 153 disposed on the active layer 154, and an n-type electrode 152 disposed on the n-type semiconductor layer 153 with being spaced apart from the p-type electrode 156 in a horizontal direction.

Alternatively, the semiconductor light emitting device 250 may have a vertical structure.

Referring to FIG. 3, the vertical type semiconductor light emitting device includes a p-type electrode 256, a p-type semiconductor layer 255 formed on the p-type electrode 256, an active layer 254 formed on the p-type semiconductor layer 255, an n-type semiconductor layer 253 formed on the active layer 254, and an n-type electrode 252 formed on the n-type semiconductor layer 253.

In addition, the plurality of semiconductor light emitting devices 250 constitute a light emitting device array and an insulating layer is interposed between the plurality of light emitting devices. However, the present disclosure is not necessarily limited thereto, and but alternatively employs a structure in which an adhesive layer fully fills a gap between the semiconductor light emitting devices without the insulating layer.

The insulating layer may be a transparent insulating layer including silicon oxide (SiOx) or the like. As another example, the insulating layer may be formed of epoxy having excellent insulation characteristic and low light absorption, a polymer material such as methyl, phenyl-based silicone and the like, or an inorganic material such as SiN, Al2O3 and the like, in order to prevent shorting between electrodes.

Although the embodiments of the semiconductor light emitting device has been described above, the present disclosure is not limited to the semiconductor light emitting device but may be alternately realized through various semiconductor light emitting devices.

The lamp according to the present disclosure realizes a stereoscopic illumination pattern and can give various functions to a single lamp by changing the illumination pattern.

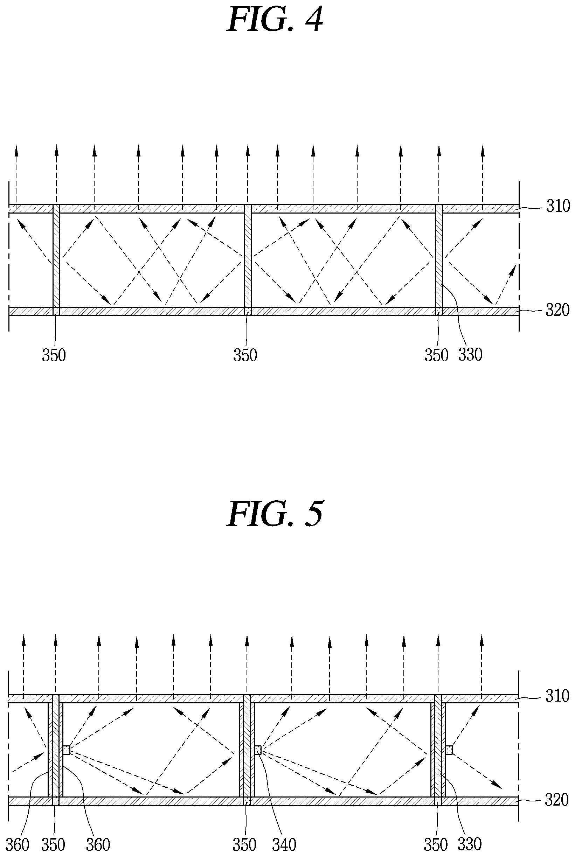

FIG. 4 is a conceptual view illustrating a cross section of a lamp according to the present disclosure.

Referring to FIG. 4, the lamp according to the present disclosure may include a half mirror 310, a reflector 320, a light guide 330, and a plurality of light sources 350. Hereinafter, each of the constituent elements will be described, and a coupling relationship between the constituent elements will be described.

The half mirror 310 reflects a part of light entering a lower surface and discharges another part outside. For example, the half mirror 310 may reflect 50 % of the light entering the lower surface and transmit the remaining light therethrough. Reflectance or transmittance of the half mirror 310 may vary depending on a material of the half mirror 310.

Meanwhile, the half mirror 310 is not necessarily disposed at an outermost portion of the lamp according to the present disclosure. Light passing through an upper surface of the half mirror 310 may be discharged to the outside through an additional structure overlapping the upper surface. For example, the lamp according to the present disclosure may include a lens, a protective layer, and the like which overlap the upper surface of the half mirror 310 and are disposed at an outer side than the half mirror 310. However, since these additional configurations are well known in the art, a detailed description thereof will be omitted.

Although only the half mirror 310 and components disposed inside the half mirror 310 are described herein, the present disclosure does not exclude that additional components are disposed outside the half mirror 310.

The reflector 320 is disposed below the half mirror 310 and is disposed to face the lower surface of the half mirror 310. The light reflected by the reflector 320 is directed to the lower surface of the half mirror 310. The light reflected from the lower surface of the half mirror 310 is directed to the reflector 320. The light which is incident between the reflector 320 and the half mirror 310 may be repeatedly reflected between the half mirror 310 and the reflector 320.

Meanwhile, the light guide 330 is disposed between the half mirror 310 and the reflector 320, and has one end and another end. The light guide 330 totally reflects a part of light entering the one end and discharges the totally reflected light to the another end. The another end is disposed to penetrate the half mirror 310.

Specifically, the light guide 330 may extend from the reflector 320 in a direction perpendicular to a plane on which the reflector 320 is provided to penetrate the half mirror 310.

The light sources are disposed to overlap a one end of the light guide 330 so that the light emitted from each of the light sources 350 is incident to the one end. The light sources may be disposed to be spaced apart from each other by a predetermined distance, and the light guide may be disposed to overlap each of the light sources.

In one embodiment, the reflector 320 may include a plurality of holes, and each of the light sources 350 may be disposed in the hole provided in the reflector 320. One end of the light guide 330 is disposed in the hole. Accordingly, most of the light emitted from the light sources 350 is incident to the one end of the light guide 330.

In another embodiment, the reflector 320 may have a plurality of recess units. Each of the light sources 350 may be disposed inside the recess unit provided in the reflector 320. One end of the light guide 330 is disposed inside the recess unit. Accordingly, most of the light emitted from the light sources 350 is incident to the one end of the light guide 330.

In the above-described two embodiments, each of the light sources 350 is disposed on the reflector 320. On the other hand, each of the light sources 350 may be disposed at a lower side of the reflector 320.

In one embodiment, each of the light sources 350 may be disposed at a lower side of the reflector 320. The light guide 330 penetrates the reflector 320, and one end of the light guide 330 overlaps the light sources 350. Accordingly, light emitted from the light sources 350 may be incident to the one end of the light guide 330.

Since another end of the light guide 330 is disposed to pass through the half mirror 310, a part of the light entering one end of the light guide 330 passes through the half mirror 310 and is immediately discharged outside. Accordingly, a bright illumination pattern is formed around the light guide.

Meanwhile, a part of the light emitted from the light sources 350 then incident to the one end of the light guide 330 is repeatedly reflected between the half mirror 310 and the reflector 320, and then discharged outside. As a result, a stereoscopic illumination pattern may be formed.

In detail, the light guide 330 has a plurality of side surfaces connecting the one end and the another end, and a part of the light incident to the one end of the light guide 330 is discharged to any one of the plurality of side surfaces, then repeatedly reflected between the half mirror 310 and the reflector 320, and then discharged outside.

On the other hand, light failed to be incident to the one end of the light guide 330 but incident between the half mirror 310 and the reflector 320 is also repeatedly reflected between the half mirror 310 and the reflector 320, then discharged outside.

Meanwhile, in order to increase a brightness of the stereoscopic illumination pattern, some of the light sources 350 may be disposed so as not to overlap the light guide 330. A light source not overlapping the light guide 330 may be disposed between the light guides 330.

Light emitted from the light source not overlapping the light guide 330 is discharged between the half mirror 310 and the reflector 320, then is repeatedly reflected between the half mirror 310 and the reflector 320 to be discharged outside. Accordingly, since the light emitted from the light source not overlapping the light guide 330 is used only to form a stereoscopic illumination pattern, a brightness of the stereoscopic illumination pattern formed on the lamp may increase.

In summary, the present disclosure allows a stereoscopic illumination pattern to be formed around a bright illumination pattern formed through the light guide 330. As described above, the present disclosure realizes a stereoscopic illumination pattern by using the half mirror 310, the reflector 320, and the light guide 330.

Hereinafter, various modified embodiments of the lamp according to the present disclosure will be described.

FIG. 5 is a conceptual view illustrating a cross section of a lamp including an auxiliary light source.

Referring to FIG. 5, the lamp according to the present disclosure may further include a plurality of side reflectors 360 disposed to cover the plurality of side surfaces provided on the light guide 330, and an auxiliary light source 340 disposed on the side reflector.

The side reflector 360 reflects a light entering the one end of the light guide 330 and directed to a side surface of the light guide 330. As a result, the side reflector 360 increases a quantity of light directed to the another end of the light guide 330 to increase a quantity of light of the lamp. The light incident to the one end of the light guide 330 by the side reflector 360 is mostly discharged to the another end.

Meanwhile, the auxiliary light source 340 emits light between the half mirror 310 and the reflector 320. To this end, the auxiliary light source 340 is disposed between the half mirror 310 and the reflector 320. Light emitted from the auxiliary light source 340 is repeatedly reflected by the half mirror 310, the reflector 360, and the side reflector 360, then discharged outside. As a result, a stereoscopic illumination pattern may be formed.

As described above, the present disclosure realizes a relatively bright illumination pattern through the plurality of light sources, and realizes a stereoscopic illumination pattern through the auxiliary light source.

Meanwhile, the present disclosure may realize a stereoscopic illumination pattern by using a surface light source.

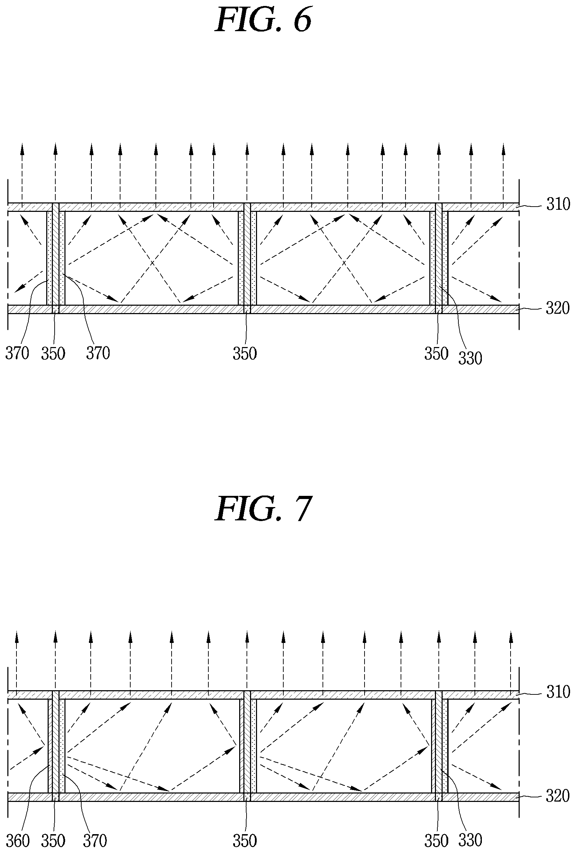

FIG. 6 is a conceptual view illustrating a cross section of a lamp including a surface light source.

Referring to FIG. 6, the present disclosure may further include a surface light source 370 disposed to cover side surfaces of the light guide.

The surface light source 370 emits light between the half mirror 310 and the reflector 320. To this end, the surface light source 370 is disposed between the half mirror 310 and the reflector 320. Light emitted from the surface light source 370 is repeatedly reflected between the half mirror 310 and the reflector 320, then discharged outside. As a result, a stereoscopic illumination pattern may be formed.

Here, the surface light source 370 is a light source that can be recognized as a surface when moved away from the light source by a predetermined distance. Accordingly, the surface light source 370 does not necessarily have a light emitting area in a planar shape, but may be a light source in which point light sources are arranged in an array form.

Meanwhile, when the light guide 330 extends perpendicular to a plane on which the reflector 320 is provided, the surface light source 370 disposed on the side surface of the light guide 330 may be arranged perpendicular to the plane on which the reflector 320 is provided.

Meanwhile, the surface light source 370 may be configured to reflect a light entering the one end of the light guide 330 and directed to the side surface of the light guide 330. As a result, the surface light source 370 increases a quantity of light directed to the another end of the light guide 330 to increase a quantity of light of the lamp. The light incident to the one end of the light guide 330 by the surface light source 370 is mostly discharged to the another end.

As described above, the present disclosure realizes a relatively bright illumination pattern through the plurality of light sources, and realizes a stereoscopic illumination pattern through the surface light source.

Meanwhile, the present disclosure may realize a stereoscopic illumination pattern by using the side reflector and the surface light source.

FIG. 7 is a conceptual view illustrating a cross section of the lamp including the surface light source and the side reflector according to the present disclosure.

Referring to FIG. 7, the lamp according to the present disclosure may include the side reflector 360 and the surface light source 370 disposed to cover some of the plurality of side surfaces. The side reflector 360 and the surface light source 370 may be disposed to face each other, and light emitted from the surface light source 370 may be reflected by the side reflector 360.

The surface light source 370 emits light between the half mirror 310 and the reflector 320. Light emitted from the surface light source 370 is repeatedly reflected by the half mirror 310, the reflector 320, and the side reflector 360, then discharged outside. As a result, a stereoscopic illumination pattern may be formed.

Meanwhile, the side reflector 360 and the surface light source 370 may be configured to reflect a light entered the one end of the light guide 330 and directed to the side surface of the light guide 330. As a result, the side reflector 360 and the surface light source 370 increases a quantity of light directed to the another end of the light guide 330 to increase a quantity of light of the lamp.

As described above, the present disclosure may realize a stereoscopic illumination pattern by using the side reflector and the surface light source.

Meanwhile, the present disclosure may further include a controller configured to receive a control command generated during a driving of a vehicle and selectively turn on the light sources based on the control command.

Here, the control command may be generated by a sensing result of a sensing unit disposed in the vehicle or a user input applied through an interface unit.

The sensing unit may sense a status of the vehicle. The sensing unit may include a posture sensor (e.g., a yaw sensor, a roll sensor, a pitch sensor, etc.), a collision sensor, a wheel sensor, a speed sensor, a tilt sensor, a weight-detecting sensor, a heading sensor, a gyro sensor, a position module, a vehicle forward/backward movement sensor, a battery sensor, a fuel sensor, a tire sensor, a steering sensor by a turn of a handle, a vehicle internal temperature sensor, a vehicle internal humidity sensor, an ultrasonic sensor, an illumination sensor, an accelerator position sensor, a brake pedal position sensor, and the like.

The sensing unit may acquire sensing signals with respect to vehicle-related information, such as a posture, a collision, an orientation, a position (GPS information), an angle, a speed, an acceleration, a tilt, a forward/backward movement, a battery, a fuel, tires, lamps, internal temperature, internal humidity, a rotated angle of a steering wheel, external illumination, pressure applied to an accelerator, pressure applied to a brake pedal and the like.

The sensing unit may further include an accelerator sensor, a pressure sensor, an engine speed sensor, an air flow sensor (AFS), an air temperature sensor (ATS), a water temperature sensor (WTS), a throttle position sensor (TPS), a TDC sensor, a crank angle sensor (CAS), and the like.

The interface unit may serve as a path allowing the vehicle to interface with various types of external devices connected thereto. For example, the interface unit may be provided with a port connectable with a mobile terminal, and connected to the mobile terminal through the port. In this instance, the interface unit may exchange data with the mobile terminal.

The controller disposed in the vehicle may generate a control command for controlling the lamp based on a sensing result of the sensing unit or a user input applied through the interface unit.

The controller disposed in the lamp may receive the control command and change the illumination pattern corresponding to the tail lamp to the illumination pattern corresponding to a turn signal lamp.

In one embodiment, the controller may turn on at least some of the light sources disposed on the lamp to realize a vehicle's tail lamp. When a control command corresponding to a turn signal is received, the controller turns off at least some of the light sources, and, in a state that the at least some of the light sources are all turned off, sequentially turns on the at least some of the light sources in one direction until the at least some of the light sources are all turned on. Accordingly, a turn signal lamp may be implemented.

Here, a time interval from when one of the at least some of the light sources is turned on until when all of the at least some of the light sources are turned on may range from 115 to 195 ms.

It will be apparent to those skilled in the art that the present disclosure may be embodied in other specific forms without departing from the spirit or essential characteristics thereof.

In addition, the above detailed description should not be construed as limiting in all aspects and should be considered illustrative. The scope of the present disclosure should be determined by rational interpretation of the appended claims, and all changes within the scope of equivalents of the present disclosure are included in the scope of the present disclosure.

## Claims

1. A lamp, comprising:
a half mirror having an upper surface and a lower surface, and configured to reflect a part of light entering the lower surface and another part to be discharged outside;
a reflector disposed to face the lower surface of the half mirror;
light guides disposed between the half mirror and the reflector, each having one end and another end, so that a part of light incident to the one end is totally reflected to be discharged to the another end; and
a plurality of light sources emitting light,
wherein the one end overlaps the light source, so that light emitted from the light source is incident to the one end, and the another end of the light guide penetrates the half mirror.

2. The lamp of claim 1, wherein the light guide extends from the reflector in a direction perpendicular to a plane on which the reflector is provided and penetrates the half mirror.

3. The lamp of claim 2, wherein the light guide has a plurality of side surfaces connecting the one end and the another end, and a part of the light incident to the one end is discharged to the plurality of side surfaces and repeatedly reflected by the half mirror and the reflector.

4. The lamp of claim 3, wherein the light sources are disposed to be spaced apart from each other by a predetermined distance, and
wherein the light guide is arranged to overlap each of the light sources.

5. The lamp of claim 1, wherein the light guide has a plurality of side surfaces connecting the one end and the another end, and
wherein the lamp further comprises:
a plurality of side reflectors disposed to cover the plurality of side surfaces; and
an auxiliary light source disposed on the side reflector.

6. The lamp of claim 5, wherein the auxiliary light source is disposed between the half mirror and the reflector so that light emitted from the auxiliary light source is repeatedly reflected between the half mirror and the reflector.

7. The lamp of claim 1, wherein the light guide has a plurality of side surfaces connecting the one end and the another end, and
wherein the lamp further comprises surface light sources disposed to cover the plurality of side surfaces.

8. The lamp of claim 7, wherein the surface light source is disposed between the half mirror and the reflector and is disposed perpendicular to a plane on which the reflector is provided so that light emitted from the surface light source is repeatedly reflected between the half mirror and the reflector.

9. The lamp of claim 1, wherein the light guide has a plurality of side surfaces connecting the one end and the another end, and
wherein the lamp further comprises:
a side reflector disposed to cover some of the plurality of side surfaces; and
a surface light source disposed to cover a remaining part of the plurality of side surfaces.

10. The lamp of claim 9, wherein the side reflector and the surface light source are disposed to face each other.

11. The lamp of claim 1, wherein the light guides overlap some of the light sources.

12. The lamp of claim 11, wherein at least one light source that does not overlap the light guide is disposed between the neighboring light guides.

13. The lamp of claim 1, further comprising a controller configured to receive a control command generated during a driving of a vehicle and selectively turn on the light sources based on the control command.

14. The lamp of claim 13, wherein the controller, in a state that at least some of the light sources are all turned off, sequentially turns on the at least some of the light sources in one direction until the at least some of the light sources are all turned on.

15. The lamp of claim 14, wherein a time interval from when one of the at least some of the light sources is turned on until when all of the at least some of the light sources are turned on ranges from 115 to 195 ms.

16. The lamp of claim 1, wherein each of the light sources is disposed between the half mirror and the reflector, and is disposed on the reflector.

17. The lamp of claim 1, wherein each of the light sources is disposed at a lower side of the reflector, and
wherein the light guide is disposed to penetrate the reflector such that the one end overlaps the light source.
